# EUROPEAN PATENT APPLICATION

(11) **EP 1 077 483 A2**
(43) Date of publication of application: **21.02.2001**
(21) Application number: 00306709.7
(22) Date of filing: 07.08.2000
(51) Int. Cl.: H01L 21/768

(54) **Method of making an integrated circuit device having a planar interlevel dielectric layer**

(30) Priority: 17.08.1999 US 376039
(71) Applicant: LUCENT TECHNOLOGIES INC., Murray Hill, New Jersey 07974-0636 (US)
(72) Inventor: Abdelgadir, Mahjoub Ali, Orlando, Florida 32828 (US); Maury, Alvaro, Orlando, Florida (US)
(74) Representative: Buckley, Christopher Simon Thirsk

(57) **Abstract**

A method of making an integrated circuit includes depositing a conductive layer, having conductive lines with gaps therebetween, adjacent a semiconductor substrate. A fluoro-silicate glass (FSG) layer is deposited by high-density plasma chemical vapor deposition (HDP-CVD), over the patterned conductive layer and to fill the gaps between conductive lines. The method further includes chemically mechanically polishing the FSG layer and depositing an undoped oxide layer on the FSG layer. Peaks of the FSG layer which correspond to the widths of the conductive metal lines are reduced by the CMP step. Thus, a subsequent conductive layer is substantially protected from exposure to fluorine from the FSG layer.

## Description

### Field Of The Invention

The present invention relates to the field of integrated circuits, and, more particularly, to integrated circuits having interlevel dielectric layers.

### Background Of The Invention

To accommodate higher packing density in present integrated circuits, metal connection to integrated circuit devices formed in a semiconductor substrate are made by multilayer interconnects. Each level of multilayer interconnects is supported over the semiconductor substrate by an interlevel dielectric. Generally, the integrated circuit structure includes a dielectric layer and metal lines are laid down in parallel strips on top of the dielectric layer. Additional levels of multilayer interconnects are formed over this dielectric layer each including additional metal interconnects and an interlevel dielectric layer.

A number of methods for depositing dielectric materials by chemical vapor deposition (CVD) are currently available. For gap fill applications, CVD methods have their advantages. They are well-known processes, and they generally require a smaller number of overall steps than spin-on methods. For damascene processes, blanket deposition is all that is required for interlevel layers, and that can be done with either a CVD or a spin-on process. Pre-metal dielectric (PMD) and shallow-trench isolation (STI) require effective gap fill capability whether damascene is used or not. For STI, high-aspect ratio (e.g. 4:1) trenches must be filled with high-quality dielectric material.

One process for dielectric gap fill applications is high-density plasma CVD (HDP-CVD). HDP-CVD films are dry, compressive, films that lend themselves well to multiple metal layer applications such as microprocessors. Since it is a plasma-based system, a typical HDP system would cost more than a tetra-exthyl oxysilane-ozone (TEOS/O₃) system, but it provides the throughput advantages of requiring fewer process steps. TEOS-ozone is used in many DRAM applications, since the market is more cost sensitive, and TEOS-ozone equipment costs less. TEOS-ozone films, as others that depend on a flow mechanism, must be annealed, which adds steps and increases production time.

The HDP-CVD oxide deposition process is actually a deposition-etchback process, where both are performed simultaneously. The plasma is a high-density mixture containing oxygen and argon. A DC bias pulls oxygen to the wafer surface where it reacts with silane (SiH₄) to form SiO₂. The argon simultaneously sputters deposited material away. The etchback is designed to remove overhang of the deposited material at the top of the gap. Although much of the deposited material is removed, it provides a time savings over some other methods since no anneal is required.

HDP-CVD was originally developed for interlevel dielectric (ILD) applications, but it also deposits high-quality material for STI, PMD and nitride etch-stop applications. Also, with the removal of the sputtering component of the plasma, it becomes a PECVD capping layer tool to prepare for chemical mechanical polishing (CMP). The etch:deposition (E:D) ratio, is usually kept somewhere between 0.14 and 0.33, and is controlled by the ratio of the gases, the chamber pressure, the ion-to-neutral flux ratio, the ion energy and the rf bias on the substrate.

HDP-CVD is used for depositing fluorosilicate glass (FSG), a low dielectric constant (low-k) dielectric. Low-k dielectrics reduce capacitive coupling between adjacent metal layers. Furthermore, an ideal low-k dielectric offers low-k as well as low leakage, low thermal coeffcient of ezpansion, high dielectric breakdown voltage, low water absorption, for example. FSG layers, which are a silicon oxyfluoride (FₓSiO_{y}), are known to have a dielectric constant of about 3.2-3.6, depending on the fluorine concentration. The high electronegativity of fluorine reduces the polarizability of the film, decreasing its dielectric constant. FSG layers are formed by adding silicon tetrafluoride (SiF₄) to the silane (SiH₄), O₂ and argon gases. HDP-CVD of FSG layers is relatively time consuming and expensive.

Chemical-mechanical polishing (CMP) is employed to planarize layers deposited on semiconductor wafers. Chemical mechanical polishing involves holding and rotating a semiconductor wafer against a wetted polishing platen under controlled chemical, pressure and temperature conditions. Typically a slurry solution is used as the abrasive fluid. The polishing mechanism is a combination of mechanical action and the chemical reaction of the material being polished with the slurry solution.

U.S. Patent No. 5,807,785 to Ravi, for example, discloses a sandwich silicon dioxide layer for filling gaps in the metal layers on a semiconductor substrate. A first layer is formed by plasma-enhanced CVD (PECVD) and a second layer is formed by sub-atomic CVD (SACVD) to achieve a low dielectric constant. Also, U.S. Patent No. 5,759,906 to Lou discloses a planarization method for dielectric layers using a multilayer of spin-on glass (SOG) which is deposited and baked after the deposition of each layer.

There is a need for a planarized low-k interlevel dielectric layer including an HDP-CVD FSG layer which is more cost effective and substantially decreases the risk of exposing the metal in the conductive layers to potential fluorine attack.

### Summary Of The Invention

In view of the foregoing background, it is therefore an object of the invention to provide a method of making a planarized low-k interlevel dielectric layer including an HDP-CVD FSG layer which protects the conductive layers from fluorine exposure.

This and other objects, features and advantages in accordance with the present invention are provided by a method of making an integrated circuit including depositing a conductive layer adjacent a semiconductor substrate, and patterning the conductive layer to form conductive lines having gaps therebetween. The conductive layer may be a metal layer and may comprise at least one of aluminum and copper. A fluoro-silicate glass layer is deposited by high-density plasma chemical vapor deposition, over the patterned conductive layer and to fill the gaps between conductive lines. The method further includes chemically mechanically polishing the FSG layer and depositing an undoped oxide layer on the FSG layer. Peaks of the FSG layer which correspond to the widths of the conductive metal lines are reduced by the CMP step. Thus, a subsequent conductive layer is substantially protected from exposure to fluorine from the FSG layer.

The undoped oxide layer may be chemically mechanically polished and may comprise an undoped-silicate glass layer. Also, the method may include the step of forming a protective dielectric layer on the patterned conductive layer prior to depositing the FSG layer.

Preferably, the FSG layer is chemically mechanically polished for about 15-30 seconds or an equivalent time necessary to remove a blanket oxide thickness of about 150 nanometers. The FSG layer may be deposited to a thickness at least 250 nanometers higher than a thickness of the conductive layer and may be chemically mechanically polished to a thickness of at least 100 nanometers higher than the thickness of the conductive layer. Furthermore, the step of patterning the conductive layer may include forming at least some of the conductive lines with different widths wherein the peaks of the FSG layer have heights which correspond to the widths of the conductive lines.

### Brief Description Of The Drawings

FIG. 1 is a flowchart generally illustrating the method steps for making an integrated circuit device with an interlevel dielectric layer in accordance with the present invention.
FIGS. 2-4 are cross-sectional views of an integrated circuit device illustrating the formation thereof in accordance with the present invention.

### Detailed Description Of The Preferred Embodiments

The present invention will now be described more fully hereinafter with reference to the accompanying drawings, in which preferred embodiments of the invention are shown. This invention may, however, be embodied in many different forms and should not be construed as limited to the embodiments set forth herein. Rather, these embodiments are provided so that this disclosure will be thorough and complete, and will fully convey the scope of the invention to those skilled in the art. Like numbers refer to like elements throughout. The dimensions of layers and regions may be exaggerated in the figures for clarity.

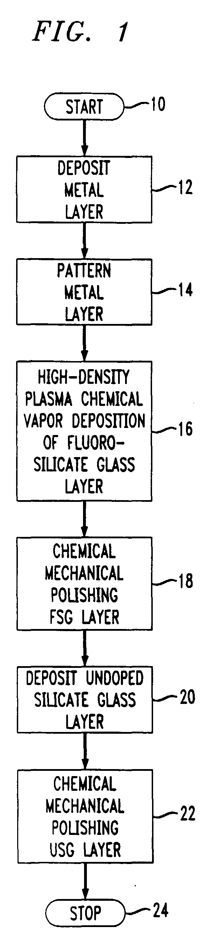

Referring to FIG. 1, the basic steps of the method of making an integrated circuit including an interlevel dielectric layer in accordance with the present invention are now described. In accordance with the present invention, the method begins (Block **10**) and a conductive metal layer is deposited at Block **12**. Such a metal layer may be formed or deposited by electrodeposition, electroplating or CVD techniques known to the skilled artisan. The metal layer is patterned (Block **14**) to form metal lines having gaps therebetween. Such metal lines may have different widths and may be patterned by well known photolithography techniques as would readily be appreciated by those skilled in the art.

Next, at Block **16**, an FSG layer is formed by high-density plasma chemical vapor deposition (HDP-CVD). The FSG layer fills in the gaps between the metal lines and covers the metal layer thereby forming peaks corresponding to or overlying the metal lines. At Block **18**, the peaks of the FSG layer are chemically mechanically polished to reduce the height thereof. This is a relatively short CMP step to reduce the FSG peaks above the metal lines without exposing the metal lines.

CMP is employed to convert a conformal deposited FSG layer into a substantially more planar oxide surface. Without CMP, the conformal FSG layer conforms to the shape of the layer of patterned metal lines. Fluctuations in the surface of the conformal oxide layer exist above metal lines in the metal layer. With CMP, FSG peaks on the surface of a wafer are reduced, producing a more planar layer of oxide above the metal lines. An undoped oxide layer, such as undoped silicate glass (USG), is formed on the FSG layer at Block **20** and then chemically mechanically polished (Block **22**) to planarize the interlevel dielectric layer, if necessary, before ending the process (Block **24**).

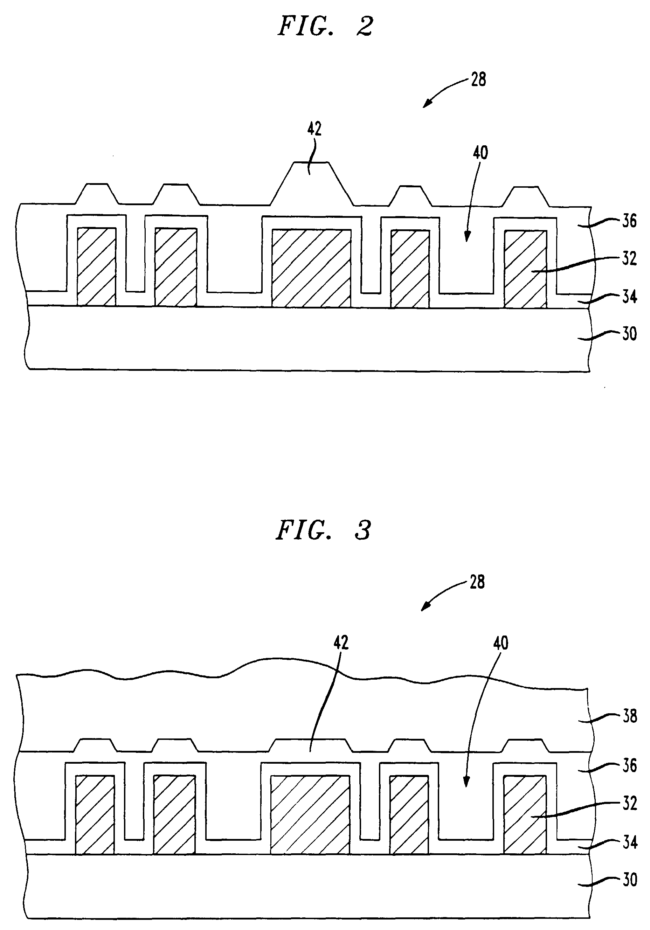

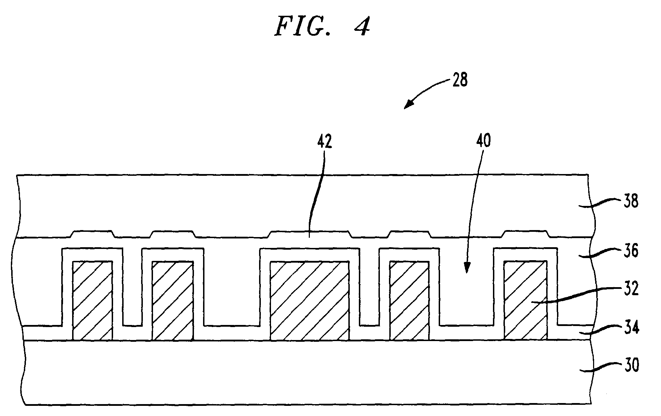

Referring to the cross-sectional views FIGS. 2-4, an integrated circuit device **28** including an interlevel dielectric layer in accordance with the present invention is now described. The semiconductor substrate **30** is preferably silicon, or may be silicon or a polysilicon layer or structure formed on the substrate. A plurality of devices, such as transistors (not shown), are formed in the substrate **30** using well known techniques. The semiconductor device **28** may include a first dielectric layer (not shown) adjacent the substrate **30**. Such a first dielectric layer is formed from any suitable dielectric, e.g., silicon dioxide, silicon nitride and/or any material or alloy of material having a desired dielectric constant. Other suitable materials include tantalum pentoxide and barium strontium titantate, for example.

The integrated circuit **28** includes a plurality of conductive lines **32** on the substrate **30**. The conductive lines **32** are formed by a conventional subtractive etch technique in which a conductive layer, such as aluminum and/or copper, is electrodeposited on the substrate **30**, and a photoresist layer (not shown) is formed and patterned over the conductive layer using well known photolithography techniques to define the locations where the conductive lines **32** are to be formed. Next, the conductive layer is etched in the desired pattern to form the conductive lines **32** having gaps **40** therebetween.

The integrated circuit **28** may include a protective dielectric layer **34** over the conductive lines **32**. Such a protective dielectric layer **34** may be formed of USG and may be grown, deposited or formed by any other suitable technique. The protective dielectric layer **34** serves to protect the conductive lines **32** from exposure to potentially harmful fluorine in the subsequently deposited FSG layer **36**.

The low-k FSG layer **36** is formed by HDP-CVD to a desired height and has a dielectric constant of about 3.2-3.6, depending on the fluorine concentration. For example, the height of the deposited FSG layer **36** may be at least 250 nanometers above the conductive lines **32**. The HDP-CVD oxide deposition step is a deposition-etchback process, where both are performed simultaneously. The plasma is a high-density mixture containing oxygen and argon. A DC bias pulls oxygen to the wafer surface where it reacts with silane (SiH₄) and/or silicon tetrafluoride (SiF₄) to form SiO₂. The argon simultaneously sputters deposited material away. HDP-CVD layers are dry, compressive layers that lend themselves well to multiple metal layer applications such as microprocessors.

As illustrated in FIG. 2, HDP-CVD FSG is a conformal oxide layer having peaks **42** formed above the conductive lines **32**. The height of a peak **42** corresponds to the respective widths and/or spacing of the conductive lines **32**. The widest conductive lines **42** (e.g. above a predetermined dimension) may have the full height of the deposited FSG layer thereon.

To reduce the height of these peaks **42**, the FSG layer is chemically mechanically polished. The integrated circuit device **28** is held and rotated against a wetted polishing platen under controlled chemical, pressure and temperature conditions. Typically a slurry solution is used as the abrasive fluid. The polishing mechanism is a combination of mechanical action and the chemical reaction of the material being polished with the slurry solution. This is a relatively short CMP step to reduce the FSG peaks **42** above the conductive lines **32** without exposing the metal lines. A typical polishing rate for CMP in other etchback steps is about 250 nanometers/minute, but in the present invention, the FSG layer **36** is polished for about 15-30 seconds (or an equivalent time to remove about 150 nm of a blanket oxide). This is done to leave about 100 nm of FSG **36** on the conductive lines **32**. The CMP step substantially eliminates the variation in height of the peaks **42** as each of the resulting polished peaks **42** has substantially the same height. Because the height of the peaks **42** of the FSG layer **36** have been reduced, the potential of subsequent conductive lines being exposed to fluorine has been substantially decreased.

As also illustrated in FIG. 2, the integrated circuit **28** includes an undoped oxide layer **38**. This undoped oxide layer **38** may be undoped silicate glass (USG), for example, and may be formed by any suitable technique know to those skilled in the art. The undoped oxide layer **38** is then planarized by CMP if necessary as illustrated in FIG. 3. The FSG layer **36** and the undoped oxide layer **38** form a composite dielectric layer. Such a composite dielectric layer allows the integration of a low-k dielectric material, such as FSG, as the gap fill dielectric without having to use a relatively thick FSG layer which is relatively expensive. Furthermore, a planar interlevel dielectric layer including a low-k dielectric, which protects the conductive layers from fluorine exposure, is achieved.

Many modifications and other embodiments of the invention will come to the mind of one skilled in the art having the benefit of the teachings presented in the foregoing descriptions and the associated drawings. Therefore, it is understood that the invention is not to be limited to the specific embodiments disclosed, and that modifications and embodiments are intended to be included within the scope of the appended claims.

## Claims

1. A method of making an integrated circuit comprising the steps of:
forming a conductive layer, having conductive lines with gaps therebetween, adjacent a semiconductor substrate;
depositing a fluoro-silicate glass (FSG) layer, by high-density plasma chemical vapor deposition (HDP-CVD), over the patterned conductive layer and to fill the gaps between conductive lines;
chemically mechanically polishing the FSG layer; and
depositing an undoped oxide layer on the FSG layer.

2. The method according to Claim 1, wherein the FSG layer has peaks corresponding to the conductive lines, and wherein the FSG layer is chemically mechanically polished to reduce a height of the peaks.

3. The method according to Claim 1, wherein the step of patterning the conductive layer includes forming at least some of the conductive lines with different widths, and wherein the step of depositing the FSG layer includes forming peaks having larger heights for larger widths of the conductive lines, and wherein the step of chemically mechanically polishing the FSG layer includes reducing the height of the peaks to a substantially uniform height.

4. The method according to claim 1, wherein the conductive layer is a metal layer and comprises at least one of aluminum and copper.

5. The method according to claim 1, wherein the FSG layer is chemically mechanically polished to remove about 150 nanometers.

6. A method of making an integrated circuit comprising the steps of:
forming a metal layer, having metal lines with gaps therebetween, adjacent a semiconductor substrate;
depositing a fluoro-silicate glass (FSG) layer, by high-density plasma chemical vapor deposition (HDP-CVD), over the patterned metal layer and to fill the gaps between metal lines, the FSG layer having peaks corresponding to the metal lines;
chemically mechanically polishing the FSG layer to reduce a height of the peaks to a substantially uniform height;
depositing an undoped oxide layer on the FSG layer; and chemically mechanically polishing the undoped oxide layer.

7. The method according to claim 1 or 6, wherein the undoped oxide layer comprises an undoped-silicate glass layer (USG).

8. The method according to claim 6, wherein the step of patterning the metal layer includes forming at least some of the metal lines with different widths, and wherein the step of depositing the FSG layer includes forming the peaks with heights which correspond to the widths of the metal lines.

9. A method of making a composite interlevel dielectric for an integrated circuit including metal lines having gaps therebetween, the method comprising the steps of:
depositing a fluoro-silicate glass (FSG) layer over the metal lines and to fill the gaps between the metal lines, the FSG layer having peaks overlying the metal lines;
chemically mechanically polishing the FSG layer to reduce a height of the peaks to a substantially uniform height; and
depositing an undoped oxide layer on the FSG layer.

10. The method according to claim 1 or 9, further comprising the step of chemically mechanically polishing the undoped oxide layer.

11. The method according to claim 1,6 or 9, further comprising the step of forming a protective dielectric layer on, as the case may be, the metal or conductive layer or the metal lines prior to depositing the FSG layer.

12. The method according to claim 9, wherein the metal lines comprise at least one of aluminum and copper.

13. The method according to claim 1,6 or 9, wherein the FSG layer is chemically mechanically polished for about 15-30 seconds.

14. The method according to claim 1,6 or 9,
wherein the FSG layer is deposited to a thickness at least 250 nanometers higher than a thickness of, as the case may be, the metal or conductive layer or the metal lines.

15. The method according to claim 1,6,9 or 14, wherein the FSG layer is chemically mechanically polished to a thickness of at least 100 nanometers higher than the thickness of, as the case may be, the metal or conductive layer or the metal lines.

16. The method according to claim 9, wherein at least some of the metal lines have different widths, and wherein the step of depositing the FSG layer includes forming the peaks with heights which correspond to the widths of the metal lines.
